(19) Europäisches Patentamt European Patent Office Office européen des brevets

(11) **EP 2 597 480 B1**

(12) **FASCICULE DE BREVET EUROPEEN**

(45) Date de publication et mention
de la délivrance du brevet:
**21.01.2015 Bulletin 2015/04**

(51) Int Cl.:
***G01R 33/09*** *(2006.01)*

(21) Numéro de dépôt: **12193866.6**

(22) Date de dépôt: **22.11.2012**

(54) **Capteur de champ magnétique**

Magnetfeldsensor

Magnetic field sensor

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **25.11.2011 FR 1160781**

(43) Date de publication de la demande:
**29.05.2013 Bulletin 2013/22**

(73) Titulaire: **Commissariat à l'Énergie Atomique
et aux Énergies Alternatives
75015 Paris (FR)**

(72) Inventeurs:
• **Delaet, Bertrand
38190 BERNIN (FR)**
• **Viala, Bernard
38360 SASSENAGE (FR)**

(74) Mandataire: **Colombo, Michel et al
Brevinnov
310 avenue Berthelot
69008 Lyon (FR)**

(56) Documents cités:
**DE-A1- 10 054 016    US-A- 6 117 569
US-A1- 2004 137 275    US-A1- 2008 272 771**

**Description**

L'invention concerne un capteur de champ magnétique ainsi qu'un capteur de courant incorporant ce capteur de champ magnétique. L'invention concerne également un barreau magnétorésistif utilisé dans ces capteurs.

Typiquement, les capteurs de courant concernés fonctionnent pour des courants variant de $10\mu A$ à 5000A, en particulier donc pour les forts courants, supérieurs à 100 A.

Par matériau non magnétique, on désigne par la suite un matériau ne présentant pas d'aimantation mesurable en champ nul. Un tel matériau non magnétique est donc dépourvu de Fer, de Cobalt et de Nickel.

Un capteur connu de courant comporte :

- un conducteur électrique s'étendant le long d'une direction X, et
- un capteur connu de champ magnétique fixé sans aucun degré de liberté à ce conducteur électrique.

Le capteur connu de champ magnétique comporte au moins un barreau magnétorésistif comprenant un empilement d'au moins :

- une première couche magnétique , dite « couche de référence » dont la direction d'aimantation est fixe et perpendiculaire à la direction longitudinale à plus ou moins 10° près,
- une seconde couche magnétique, dite « couche libre », dont l'axe de plus facile aimantation est parallèle à la direction longitudinale et dont l'aimantation peut tourner lorsqu'elle est soumise au champ magnétique à mesurer, et
- une couche non magnétique, dite « espaceur », interposée entre les deux couches précédentes pour former une jonction tunnel ou une vanne de spin.

Dans les capteurs connus, la longueur du barreau dans sa direction longitudinale est au moins vingt fois supérieure à sa plus grande largeur dans une direction transversale perpendiculaire à la direction longitudinale et parallèle aux couches de l'empilement.

Un tel capteur connu de courant est par exemple décrit dans la demande de brevet US2004/0137275. Un autre capteur connu est décrit dans le document A0 suivant :

Bill Drafts, « Magnetoresistive Current Sensor Improves Motor Drive Perfomance », Pacific Scientific - OECO, 4607 SE International Way, Milwaukie, OR 97222.

Dans ces capteurs, le rapport de forme des barreaux magnétiques est important, c'est-à-dire supérieur à vingt, quarante ou cent. Par « rapport de forme », on désigne le rapport de la longueur du barreau magnétorésistif sur sa largeur.

Ce rapport de forme important est nécessaire pour pouvoir régler la sensibilité du barreau magnétorésistif sur une très large gamme et donc permettre à ce barreau magnétorésistif de mesurer des champs magnétiques de forte intensité. En effet, plus le rapport de forme est important, plus il est difficile de faire tourner la direction d'aimantation de la couche libre. Il a donc été proposé des barreaux magnétorésistifs ayant un rapport de forme supérieur à 1000. Toutefois, ces barreaux magnétorésistifs sont alors très longs, ce qui rend le capteur encombrant.

De plus, les barreaux magnétorésistifs présentent une hystérésis. En effet, la variation de leur résistance en fonction du champ magnétique à mesurer n'est pas la même selon que le champ magnétique à mesurer augmente ou diminue. Pour éviter ce problème, la solution actuelle consiste à utiliser des sources auxiliaires qui génèrent un champ magnétique parallèlement à la direction de plus facile aimantation de la couche libre. Typiquement, ces sources auxiliaires de champ magnétique sont des aimants permanents ou des conducteurs électriques. La présence de ces sources auxiliaires accroît la complexité du capteur et son encombrement.

De l'état de la technique est connu de US6 117 569A, US2008/272771 A1 et DE 100 54 016 A1.

L'invention vise à remédier à au moins l'un de ces inconvénients. Elle a donc pour objet un capteur de champ magnétique conforme à la revendication 1.

Le fait d'exercer une contrainte mécanique sur la couche libre dans la direction longitudinale produit les mêmes effets que les sources auxiliaires de champ magnétique. Dans le capteur ci-dessus, les sources auxiliaires peuvent donc être simplifiées ou omises ce qui simplifie la fabrication du capteur.

De plus, à performance égale avec les capteurs connus dépourvus de la couche génératrice, le barreau magnétorésistif du capteur ci-dessus :

- a un rapport de forme plus petit ce qui décroit son encombrement, et/ou
- a une largeur plus grande ce qui améliore le rapport signal/bruit.

Les modes de réalisation de ce capteur de champ magnétique peuvent présenter une ou plusieurs des caractéristiques des revendications dépendantes.

Ces modes de réalisation du capteur de champ magnétique présentent en outre les avantages suivants :

- l'utilisation d'un pont de Wheatstone permet d'augmenter la sensibilité de la mesure du champ magnétique, et
- le fait que les résistances des deuxième et quatrième exemplaires du barreau magnétorésistif varient dans le même sens permet de compenser les biais de mesure liés à la présence d'un champ magnétique extérieur homogène sur toute la surface du capteur ou causés par des variations de température.

L'invention a également pour objet un capteur de courant dans lequel le capteur de champ magnétique ci-dessus est fixé au conducteur électrique de manière à ce que la direction d'aimantation de la couche de référence du barreau magnétorésistif soit perpendiculaire à la direction X à plus ou moins 10° près.

Les modes de réalisation de ce capteur de courant peuvent comporter une ou plusieurs des caractéristiques des revendications dépendantes de capteur de courant.

Ce mode de réalisation du capteur de courant présente en outre l'avantage suivant :

- placer au moins l'un des barreaux magnétorésistifs de la première branche à proximité du premier brin et au moins l'un des barreaux magnétorésistiifs de la seconde branche à proximité du second brin permet d'accroître la sensibilité du capteur de courant et limite le bruit.

L'invention a également pour objet un barreau magnétorésistif pour le capteur de champ magnétique ou de courant ci-dessus.

Les modes de réalisation de ce barreau magnétorésistif peuvent comporter une ou plusieurs des caractéristiques des revendications dépendantes de barreau magnétorésistif.

Ces modes de réalisation du barreau magnétorésistif présentent en outre les avantages suivants :

- l'utilisation d'une couche précontrainte permet d'exercer la contrainte mécanique en permanence sur la couche libre sans consommer d'énergie électrique,
- entourer la couche libre par la couche précontrainte permet d'exercer une contrainte uniaxiale dans la direction longitudinale du barreau magnétorésistif à cause du facteur de forme de ce barreau et cela même si la couche précontrainte est éloignée de la couche libre,
- utiliser une couche génératrice en forme de poutre suspendue et un actionneur commandable apte à étirer ou comprimer cette poutre permet de faire varier la contrainte appliquée sur la couche libre.

L'invention sera mieux comprise à la lecture de la description qui va suivre, donnée uniquement à titre d'exemple non limitatif et faite en se référant aux dessins sur lesquels :

- la figure 1 est une illustration schématique et en perspective d'un capteur de courant de forte intensité,
- la figure 2 est une illustration schématique et en coupe verticale de la section transversale d'un barreau magnétorésistif utilisé dans le capteur de la figure 1,
- la figure 3 est une illustration schématique en vue de dessus d'une contrainte appliquée sur une couche libre du barreau magnétorésistif de la figure 2,
- la figure 4 est un graphe illustrant la modification de la sensibilité du barreau magnétorésistif de la figure 2 causée par l'application d'une contrainte sur la couche libre,
- la figure 5 est un graphe illustrant la variation de la contrainte mécanique en fonction d'un ratio entre des débits de deux gaz différents,
- la figure 6 est un graphe illustrant l'ajustement d'une contrainte dans une couche précontrainte en fonction d'une température de recuit,
- les figures 7 et 8 illustrent la réponse, respectivement, d'un capteur de courant dépourvu de couche précontrainte et du capteur de la figure 1, et
- la figure 9 est une illustration schématique et en coupe verticale d'un autre mode de réalisation d'une couche génératrice de contrainte.

Dans ces figures, les mêmes références sont utilisées pour désigner les mêmes éléments.

Dans la suite de cette description, les caractéristiques et fonctions bien connues de l'homme du métier ne sont pas décrites en détail.

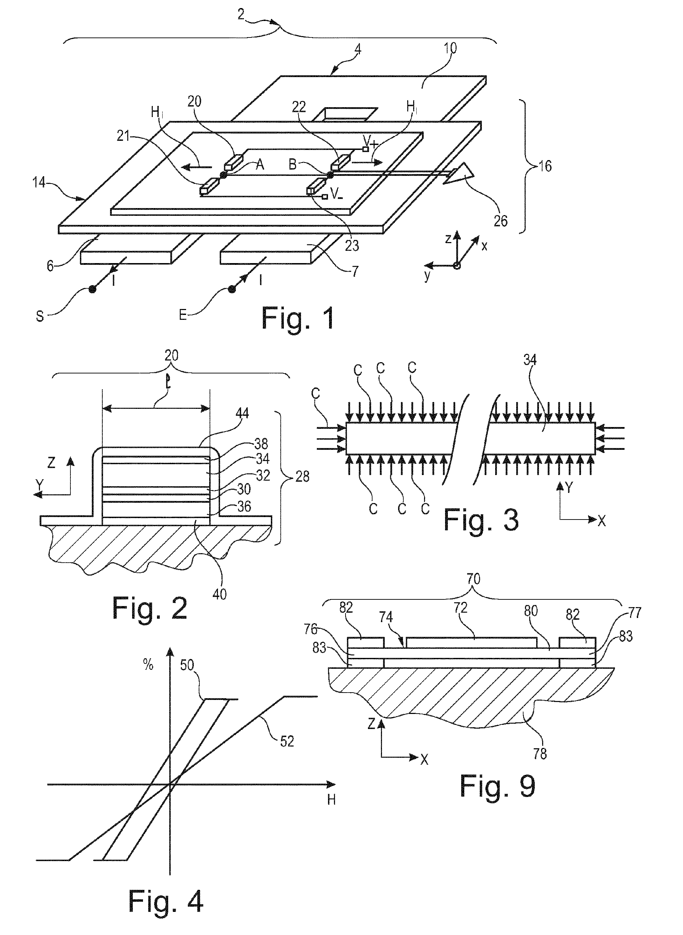

La figure 1 représente un capteur 2 de courant de forte intensité. Ce capteur 2 comporte un conducteur électrique 4. Le conducteur 4 comporte ici deux brins 6, 7 rectilignes et parallèles à une direction horizontale X d'un repère orthogonal X, Y, Z. Dans le repère X, Y, Z, la direction Y est également horizontale et la direction Z est verticale.

Ces brins 6, 7 sont électriquement raccordés entre eux par un brin supplémentaire 10 de sorte que le courant à mesurer circule dans un sens dans le brin 6 et dans le sens opposé dans le brin 7. Ici, ces brins 6, 7 et 10 forment un « U ».

Les brins 6, 7 sont également raccordés, respectivement, à des bornes E et S d'entrée et de sortie du courant à mesurer.

Un support 14 électriquement isolant repose, sans aucun degré de liberté, sur les brins 6 et 7 du conducteur 4. Par la suite, on considère qu'un matériau est isolant si sa résistivité est supérieure à 1 $\Omega$.m et, de préférence, supérieure à $10^4$ $\Omega$.m à 25°C.

Le capteur 2 comporte également un capteur 16 de champ magnétique fixé sans aucun degré de liberté sur le support 14. Ce capteur 16 comporte quatre barreaux magnétorésistifs 20 à 23 électriquement raccordés entre eux pour former un pont de Wheatstone. Un barreau magnétorésistif est un composant dont la résistivité varie en fonction du champ magnétique dans lequel il est placé. Les barreaux magnétiques dont il s'agit ici sont soit des vannes de spin soit des jonctions tunnel magnétique et non pas des dispositifs à magnétorésistance anisotrope.

Ce pont de Wheatstone comprend une première et une seconde branches électriquement raccordées en parallèle entre des potentiels de référence V+ et V-.

Le potentiel V- est par exemple la masse ou la terre. La première branche comprend successivement, en allant du potentiel V+ vers le potentiel V-, les barreaux magnétorésistifs 20 et 21 raccordés en série par l'intermédiaire d'un point milieu A. La seconde branche comprend successivement, en allant du potentiel V+ vers le potentiel V-, les barreaux 22 et 23 raccordés en série par l'intermédiaire d'un point milieu B.

Les potentiels VA et $V_B$ au niveau des points milieux A et B sont donnés par les relations suivantes :

$$V_A = (V_+ - V_-)R_2/(R_1+R_2)$$

$$V_B = (V_+ - V_-)R_4/(R_3+R_4)$$

ou $R_1$, $R_2$, $R_3$ et $R_4$ désignent les résistances, respectivement, des barreaux 20 à 23.

Ici, chaque barreau 20 à 23 a essentiellement une forme de parallélépipède rectangle dont au moins deux grandes faces s'étendent horizontalement. La direction dans laquelle s'étend principalement le barreau est appelée direction longitudinale. Ici, cette direction est horizontale et parallèle à la direction X. La direction transversale est la direction horizontale orthogonale à la direction longitudinale. Elle est parallèle à la direction Y.

Chaque barreau présente un rapport de forme important, c'est-à-dire un rapport de forme supérieur à vingt et, de préférence, supérieur à quarante ou cent. Ce rapport de forme est défini par le rapport de forme entre la longueur L du barreau sur sa largeur transversale W.

Par exemple, la longueur L est supérieure à 50 ou 100 $\mu$m et, de préférence, inférieure à 1 mm. La largeur transversale W est typiquement supérieure à 0,3 $\mu$m ou 1 $\mu$m et, de préférence, inférieure à 15 $\mu$m ou 30 $\mu$m.

Ici, les barreaux 20 et 21 sont disposés au-dessus du brin 6 de manière à être au moins deux ou trois fois plus proches de ce brin 6 que du brin 7. Ainsi, les barreaux 20 et 21 sont essentiellement sensibles au champ magnétique $H_I$ créé par le courant qui circule dans le brin 6. La direction de ce champ magnétique $H_I$ est représentée sur la figure 1 par une flèche $H_I$ qui s'étend dans la direction Y.

De façon similaire, les barreaux 22 et 23 sont disposés au-dessus du brin 7 de manière à être deux ou trois fois plus proches de ce brin 7 que du brin 6. Ainsi, les barreaux 22 et 23 sont essentiellement sensibles au champ magnétique $H_I$ créé par le courant qui circule dans le brin 7. La direction de ce champ magnétique $H_I$ est représentée sur la figure 1 par une flèche $H_I$ qui s'étend dans la direction opposée à la direction Y.

Les barreaux 21 et 22 sont agencés de sorte que leurs résistances respectives varient dans le même sens en réponse à la même variation du courant I à mesurer. Ici, les barreaux 21 et 22 sont identiques.

Dans ce mode de réalisation, les barreaux 20 et 23 sont également identiques aux barreaux 21 et 22. Toutefois, le capteur 16 est agencé de manière à ce que leur résistance ne varie pas en réponse à une variation de l'intensité du courant I dans le conducteur 4. Par exemple, le capteur 16 comprend un écran magnétique interposé entre les barreaux 20 et 23 et le conducteur 4.

Enfin, le capteur 2 comporte une unité électronique 26 de traitement. Cette unité est apte à traiter la différence de potentiels entre les points A et B pour établir l'intensité du courant I circulant dans le conducteur 4.

Les structures des différents barreaux magnétorésistifs sont identiques et seule la structure du barreau 20 est décrite plus en détail en références à la figure 2.

Le barreau 20 comporte un empilement 28, immédiatement consécutif, d'une couche de référence 30, d'un espaceur 32 et d'une couche libre 34 dans la direction verticale. Un tel empilement pour obtenir une magnétorésistance géante ou GMR (Geant Magneto-Resistance) est conventionnel. Les GMR sont également connues sous le terme « vanne de spin ». Cet empilement ne sera donc pas décrit en détail.

La couche 30 de référence a une aimantation de direction fixe et perpendiculaire à la direction X. Par « direction fixe », on désigne ici le fait que la direction d'aimantation de cette couche est beaucoup plus difficile à modifier que la direction d'aimantation de la couche libre.

Par exemple, la couche 30 est une couche ferromagnétique. Elle peut être réalisée en cobalt, en nickel ou en fer ou dans leurs alliages tels que CoFe, NiFe, CoFeB ou autres.

La direction d'aimantation de la couche 30 de référence est fixée à l'aide d'une couche 36 anti-ferromagnétique. La couche 36 sert à piéger la direction d'aimantation de la couche 30. Par exemple, la couche 36 est réalisée dans un alliage de manganèse tel que l'un des alliages suivants IrMn, PtMn, FeMn, NiMn ou autres.

L'espaceur 32 est une couche réalisée en matériau non magnétique. Cet espaceur 32 est suffisamment épais pour découpler magnétiquement les couches 30 et 34. Ici, l'espaceur 32 est une couche en matériau conducteur tel que du cuivre.

La couche libre 34 présente une direction d'aimantation qui peut plus facilement tourner que celle de la couche de référence. La direction de plus facile aimantation de cette couche 34 est ici parallèle à la direction longitudinale du barreau, c'est-à-dire ici la direction X. Par exemple, la couche 34 est une couche réalisée en matériau ferromagnétique ou un empilement de couches ferromagnétiques.

La couche libre 34 est réalisée dans un matériau magnétostrictif. Ici, ce sont les propriétés magnétostrictives inverses, également connues sous l'expression anglaise de « villari effect » qui sont exploitées. Les propriétés magnétostrictives inverses consistent à modifier les propriétés magnétiques d'un matériau en réponse à une variation de la contrainte mécanique exercée sur ce matériau. Typiquement, l'application d'une contrainte uniaxiale σ sur un matériau magnétostrictif produit un champ magnétique d'anisotropie uniaxiale appelé $H_k$ ou $H_\sigma$. L'intensité de ce champ $H_\sigma$ est donnée par la relation suivante : $H_\sigma = 3\lambda_s\sigma/M_S$, où :

- $\lambda_s$ est le coefficient de magnétostriction du matériau exprimé en ppm (partie par million ou $10^{-6}$), et
- $M_S$ est le moment magnétique du matériau à saturation.

Le coefficient $\lambda_s$ de magnétostriction est une grandeur standard en magnétisme qui traduit l'allongement relatif (du ppm au %) lorsque le matériau est saturé par application d'un champ magnétique. Les techniques de mesure sont standardisées. Par exemple, il peut s'agir d'une méthode directe telle que la déflexion d'un bilame avec l'application d'un champ magnétique et détection optique de la flexion (voir équipementier banc de mesure Lafouda® US) ou d'une méthode indirecte telle que la mesure du cycle d'hystérésis en appliquant une contrainte (voir équipementier BH looper® SHB US).

De préférence, la couche libre présente un coefficient $\lambda_s$ dont la valeur absolue est supérieure à 10, 20 ou 40 ppm ou même à 50 ou 100 ppm. Ici, on suppose que la couche libre présente des propriétés magnétostrictives positives et donc un coefficient $\lambda_s$ positif.

L'empilement 28 comprend à chaque extrémité une électrode conductrice, respectivement, 38 et 40 pour faire circuler le courant qui traverse le barreau magnétorésistif perpendiculairement au plan des couches 30, 32 et 34.

Le barreau 20 comporte également une couche 44 génératrice d'une contrainte uniaxiale en tension dans la couche libre 34 parallèlement à la direction X. Autrement dit, cette couche 44 tend à étirer la couche libre 34 dans la direction X.

On notera qu'une contrainte uniaxiale en tension dans la direction X est équivalent à exercer une contrainte en compression dans la direction Y sur la couche libre 34.

Dans ce mode de réalisation, la couche 44 est une couche précontrainte qui exerce une contrainte en compression uniforme sur l'ensemble des faces verticales de la couche libre 34. A cet effet, la couche 44 recouvre la totalité des faces verticales de la couche libre 34. Dans ce mode de réalisation, la couche 44 est directement déposée sur l'empilement 28 et recouvre la majorité des faces verticales de cet empilement ainsi que la totalité de sa face supérieure. Ainsi, la couche 44 entoure uniformément la couche libre 34. L'épaisseur de la couche 34 est supérieure à l'épaisseur de la couche libre et, typiquement, supérieure à l'épaisseur de l'empilement 28. Pour simplifier la figure 2, les rapports d'épaisseurs n'ont pas été respectés sur cette figure.

Typiquement, la couche précontrainte 44 exerce une contrainte compressive uniforme σ sur la couche libre d'au moins 10 MPa et, de préférence, d'au moins 30 ou 40 MPa. Une telle contrainte σ est dite « positive » car elle correspond à une contrainte en tension dans la direction X. A l'inverse, une contrainte σ qui comprime la couche libre 34 dans la direction X est dite « négative » et a une valeur négative.

La contrainte exercée par la couche 44 est ajustée en jouant, par exemple, sur les conditions de dépôt de cette couche 44. Ici, la contrainte σ est ajustée pour que le produit $\lambda_s\sigma$ soit positif et supérieur à 300 ppm.MPa et, de préférence, supérieur à 500 ppm.MPa ou 1000 ppm.MPa ou 5000 ppm.MPa ou 10000 ppm.MPa. Le fait que le produit $\lambda_s\sigma$ est positif signifie que si le coefficient de magnétostriction $\lambda_s$ est positif, il faut que la contrainte σ exercée soit également positive et correspond donc à une contrainte en tension. Réciproquement, si ce coefficient $\lambda_s$ est négatif, la contrainte σ doit l'être également, il s'agit alors d'une contrainte en compression.

Les conditions de dépôt sur lesquelles il faut jouer dépendent du matériau choisi pour réaliser la couche 44. En effet, il peut s'agir de la température de dépôt, de la proportion de précurseurs, de la vitesse de dépôt ou autres.

Par exemple, la couche 44 est réalisée dans un matériau électriquement isolant tel qu'un oxyde ou un nitrure. Ainsi, la couche 44 peut être réalisée en $SiH_4$, $SiO_2$, TEOS ($Si(OC_2H_5)_4$), SiN, SiON, $Si_3N_4$,..., etc. Dans le cas du SiON, la contrainte σ est ajustée en jouant sur le ratio entre les débits de gaz $N_2O$ et $NH_3$ comme montré sur le graphe de la figure 4. L'abscisse de ce graphe représente le ratio des débits de gaz $N_2O$ et de gaz $NH_3$. L'ordonnée représente la contrainte σ exprimée en MPa.

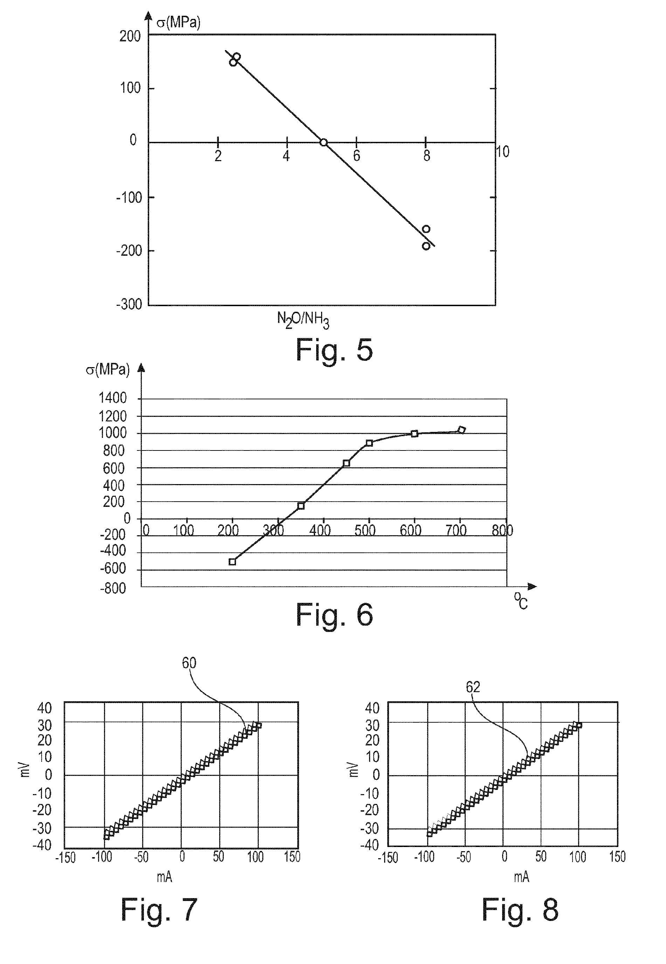

La couche 44 peut aussi être réalisée en métal non magnétique tel que du $W_2N$, Ru, Pt ou autres. Dans ce cas, la contrainte σ peut être ajustée en fonction d'une température de recuit comme illustré sur le graphe de la figure 5 dans le cas particulier du platine. Sur le graphe de la figure 5, les abscisses représentent la température de recuit utilisée tandis que les ordonnées représentent la valeur de la contrainte σ exprimée en MPa. La demande de brevet WO 2011/001293 décrit aussi des méthodes pour ajuster la contrainte σ dans une couche précontrainte.

Lorsque la couche 44 est réalisée en métal, la valeur de la contrainte σ peut être ajustée après les dépôts de l'empilement 28 et de la couche 44. A l'inverse, lorsque la couche 44 est un isolant, l'ajustement de la valeur de la contrainte σ est réalisé directement lors du dépôt de la couche 44 et ne change plus ensuite.

La figure 3 permet de comprendre comment une contrainte σ uniformément répartie sur la couche libre 34 permet d'exercer une contrainte uniaxiale dans cette couche. Sur la figure 3, la couche 34 est représentée en vue de dessus. Les flèches C uniformément réparties sur le pourtour de la couche 34 représentent la contrainte σ exercée sur ce pourtour.

Etant donné que la couche 34 est beaucoup plus longue que large, les faces verticales parallèles à la direction X sont soumises à une force beaucoup plus importante que les faces verticales d'extrémité parallèles à la direction Y. Ainsi, la contrainte en compression exercée dans la direction X est négligeable devant la contrainte en compression exercée dans la direction Y. Cette contrainte en compression dans la direction Y est équivalente à une contrainte en tension dans la direction X. Ainsi, une contrainte uniaxiale en tension apparaît dans la couche libre 34 car la contrainte en compression dans la direction X est négligeable. A contrario, le même agencement appliqué à une couche libre 34 ne présentant pas de facteur de forme important ne permet pas la création d'une contrainte uniaxiale. Un facteur de forme élevé est supérieur à 20, 40 ou 100.

La figure 4 illustre la variation de la résistivité du barreau magnétique 20 en fonction de l'intensité du champ magnétique dans lequel il est placé. L'axe des ordonnées est exprimé en pourcentage de la résistance du barreau 20 en absence de champ magnétique. L'axe des abscisses est exprimé en Tesla. La courbe 50 représente la réponse d'un barreau magnétorésistif identique au barreau 20 mais dépourvu de la couche 44. La courbe 52 représente la réponse du barreau 20 dans les mêmes conditions. La présence de la couche 44 permet de linéariser la réponse du barreau magnétorésistif et surtout de réduire ou d'éliminer l'hystérésis dans sa réponse. De plus, la couche 44 réduit encore plus la sensibilité du barreau magnétorésistif, ce qui rend possible la mesure de courant ayant une intensité encore plus grande ou la réalisation, à performance égale, d'un barreau plus court ou plus large. Ainsi, les effets de la couche 44 sont équivalents à ceux obtenus avec l'utilisation d'une source auxiliaire de champ magnétique mais sans avoir recours à une telle source auxiliaire.

La figure 7 représente les mesures délivrées par un capteur identique au capteur 2 mais équipé de source auxiliaire de champ magnétique générant dans la direction longitudinale de chaque barreau magnétorésistif un champ magnétique de 130 Oe. Les barreaux magnétorésistifs utilisés pour tracer la courbe 60 de la figure 7 sont dépourvus de couche génératrice de contrainte. Sur les figures 7 et 8, l'axe des abscisses représente l'intensité du courant à mesurer tandis que l'axe des ordonnées représente la différence de potentiels entre les points A et B exprimée en millivolt.

La figure 8 représente les mesures délivrées par le capteur 2 dans le cas où la couche 44 est agencée pour exercer une contrainte compressive $\sigma$ de 60 MPa. Comme le montre les courbes 60 (figure 7) et 62 (figure 8), les résultats obtenus sont quasiment identiques. Ainsi, la couche 44 permet de se passer complètement des sources auxiliaires de champ magnétique.

La figure 9 représente un barreau magnétorésistif 70 utilisable en lieu et place de chaque barreau 20 à 23 dans le capteur 2. Ce barreau 70 comporte un empilement 72 magnétorésistif. Cet empilement 72 est déposé sur une couche 74 génératrice de contrainte uniaxiale. Plus précisément, la couche 74 est une poutre dont les extrémités opposées 76, 77 sont ancrées sans aucun degré de liberté sur un substrat rigide 78. La partie de la poutre 74 située entre les extrémités ancrées 76, 77 définit une branche centrale 80 suspendue au-dessus du substrat 78. La poutre 74 et l'actionneur mécanique pour générer une contrainte uniaxiale dans cette poutre sont par exemple identiques à ceux décrits dans la demande de brevet FR2 905 793. En particulier, au moins l'une des extrémités 76, 77 et, de préférence, les deux extrémités ainsi que la branche centrale 80 sont réalisées en matériau piézoélectrique. Les extrémités 76, 77 sont alors interposées entre une électrode supérieure 82 et une électrode inférieure 83 pour commander et actionner ce matériau piézoélectrique.

La poutre s'étend essentiellement dans la direction longitudinale de l'empilement 72 pour générer une contrainte uniaxiale parallèle à cette direction. L'épaisseur $\underline{e}$ de la branche centrale 80 dans la direction verticale est strictement supérieure à l'épaisseur de la couche libre de l'empilement 72 et, typiquement, supérieure à l'épaisseur de l'empilement 72. Par exemple, l'épaisseur $\underline{e}$ est supérieure à $1\,\mu m$ ou $3\,\mu m$. L'épaisseur de l'empilement 72 est souvent inférieure à 100 ou 200 ou 500nm.

Pour créer efficacement une contrainte $\sigma$ dans la couche libre de l'empilement 72, les faces horizontales de la couche libre et la poutre ne doivent pas être séparées de plus d'une distance d strictement inférieur à l'épaisseur $\underline{e}$ de la poutre. De préférence, la distance d est inférieure à dix ou cent fois l'épaisseur $\underline{e}$. Ici, l'empilement 72 est, par exemple, identique à l'empilement 28 sauf que l'empilement est réalisé dans l'ordre inverse. Ainsi, la couche libre 34 et la poutre 74 sont uniquement séparés par l'électrode 38. L'épaisseur de l'électrode 38 est choisie inférieure à dix ou cent fois l'épaisseur $\underline{e}$.

Ce mode de réalisation fonctionne comme le précédent sauf que la contrainte $\sigma$ exercée sur la couche libre par la couche 74 est réglable en jouant sur la tension entre les électrodes 82 et 83.

De nombreux autres modes de réalisation sont possibles. Par exemple, l'empilement 28 peut être remplacé par un empilement formant une jonction tunnel magnétique utilisant l'effet tunnel plus connue sous l'acronyme de TMR (Tunnel magnétoresistance). Dans une jonction tunnel, l'espaceur est un matériau non magnétique isolant. Par exemple, il peut s'agir d'un oxyde ou d'un nitrure d'aluminium. Par exemple, l'espaceur est réalisé en alumine $Al_2O_3$, en oxyde de manganèse MgO ou en titanate de strontium ($SrTiO_3$) ou autres.

Dans un autre mode de réalisation, le barreau 20 est agencé de manière à ce que sa résistance varie en sens inverse de la résistance du barreau 21 lorsqu'ils subissent tous les deux la même variation de champ magnétique. De préférence, l'amplitude des variations de la résistivité des barreaux 20 et 21 en réponse à une même variation du champ magnétique sont égales à plus ou moins 10 % près. Par exemple, les barreaux 20 et 21 sont identiques mais monté en sens inverse de sorte que la direction d'aimantation de la couche de référence de l'un d'eux est en sens inverse de celle de l'autre barreau. Il est aussi possible de retourner la direction d'aimantation de la couche de référence par effet magnétothermique local. On chauffe alors la couche de référence de l'un des deux barreaux puis on applique localement un champ magnétique pour retourner la direction d'aimantation de la couche de référence de ce barreau. Les barreaux 22 et 23 sont agencés de manière similaire à ce qui vient d'être décrit pour les barreaux 20 et 21. Dans ce mode de réalisation, l'écran magnétique entre les barreaux 20 et 22 et le conducteur 4 est omis.

Il est aussi possible de conformer le conducteur 4 en méandre pour que le courant à mesurer circule dans un même sens sous les barreaux 20 et 22 et en sens opposé sous les barreaux 21 et 23. Dans ce mode de réalisation, l'écran magnétique est omis.

La couche libre peut être réalisée dans un matériau magnétique présentant des propriétés magnétostrictives négatives, ce qui correspond à un coefficient $\lambda_s$ strictement inférieur à zéro. Par exemple, la couche libre est en cobalt. Dans ce cas, la couche génératrice de la contrainte $\sigma$ est conçue pour générer une contrainte uniaxiale compressive dans la direction X et non plus, comme précédemment, dans la direction Y. Dans le cas d'une couche précontrainte telle que la couche 44, celle-ci est agencée pour exercer une contrainte $\sigma$ négative dans la direction X.

La couche 44 doit recouvrir au moins une face de l'empilement 28 qui s'étend dans la direction longitudinale du barreau. De préférence, la couche 44 recouvre cette face à partir d'une de ses extrémités jusqu'à l'extrémité opposée dans la direction longitudinale, c'est-à-dire ici le long de la direction X.

Ainsi, en variante, la couche génératrice 44 recouvre une face latérale de l'empilement 28 parallèle à la direction longitudinale. Par exemple, la couche 44 recouvre uniquement la partie des faces latérales de l'empilement 28 en vis-à-vis ou en contact direct avec les faces verticales de la couche libre 34. Ainsi, il n'est pas nécessaire que la couche 44 recouvre la face supérieure ou inférieure de cet empilement ou que la couche 44 recouvre la totalité des faces verticales de cet empilement.

A l'inverse, la couche 44 peut recouvrir uniquement la face horizontale supérieure et/ou inférieure de la couche libre 34 sans recouvrir les faces verticales de cette couche libre. Ainsi sur la figure 2, la couche 44 peut être disposée uniquement au-dessus de la couche 38 et/ou en-dessous de la couche 40. Dans ce cas, la distance $d$ maximale qui sépare la couche 44 de la face horizontale la plus proche de la couche libre 34 est inférieure à la distance $d$ précédemment décrite dans le cas de la poutre 74.

La couche 44 peut être directement en contact avec l'empilement 28 ou séparé de l'empilement 28 par une ou plusieurs couches intermédiaires. Notamment, dans le cas où la couche 44 est une couche métallique, de préférence, une couche électriquement isolante est interposée entre la couche 44 et l'empilement 28 pour ne pas mettre en court-circuit les différentes couches de l'empilement.

On choisira avantageusement de déposer l'empilement de façon à ce que la couche libre soit au plus près de la couche 44.

Ainsi, dans cette description, lorsque l'on dit que la couche 44 « recouvre » l'empilement 28, cela désigne l'un quelconque des modes de réalisation décrit ci-dessus et, en particulier, que :

- la couche précontrainte peut être indifféremment au-dessus ou en dessous de la couche libre dans l'empilement, et
- qu'elle peut être directement au contact de cette couche libre ou séparée de cette couche libre par une couche intermédiaire, par exemple, une couche d'isolation électrique ou une couche de croissance.

Dans le cas où la couche précontrainte s'étend uniquement parallèlement à l'une des faces horizontales de la couche libre, de préférence, une face horizontale de la couche libre est directement en contact avec une face horizontale correspondante de la couche précontrainte. A cet effet, l'électrode 38 ou 40 est déplacée pour être directement en contact mécanique avec la couche libre seulement par une extrémité de cette couche, par exemple, par l'intermédiaire de l'une de ses faces verticales.

Dans le cas où la couche précontrainte 34 entoure la couche libre, la couche génératrice n'a pas besoin d'être directement en contact avec la couche libre pour exercer la contrainte $\sigma$ sur cette couche libre. Par exemple, des couches intermédiaires non précontraintes séparent la couche précontrainte de la couche libre. Dans ce cas, la distance entre la couche précontrainte et la couche libre n'a pas besoin d'être inférieure à la distance $d$ précédemment définie.

De préférence, la couche de référence est réalisée dans un matériau non magnétostrictif c'est-à-dire dont la valeur absolue du coefficient $\lambda_s$ est inférieure à au moins cent fois la valeur absolue du coefficient de magnétostriction de la couche libre. Par exemple, la couche de référence est réalisée en alliage FeNi.

La couche de référence peut aussi être réalisée dans un matériau magnétostrictif. Dans ce cas là, son coefficient de magnétostriction est du même signe que le coefficient de magnétostriction de la couche libre.

La présence de la couche génératrice de contrainte peut être combinée à la présence des sources auxiliaires de champ magnétique des capteurs connus pour, par exemple, décroître l'encombrement du barreau magnétorésistif ou simplifier les sources auxiliaires ou décroître le rapport signal sur bruit du capteur.

Le barreau 20 peut avoir d'autres formes qu'un parallélépipède rectangle. Par exemple, il est conformé en méandre ou en fer à cheval. Le barreau magnétorésistif peut aussi être formé de plusieurs brins rectilignes et parallèles entre eux dont les extrémités sont recourbées pour rejoindre l'extrémité d'un brin immédiatement adjacent. Dans ce cas, chaque brin a un facteur de forme supérieur à vingt, quarante ou cent.

L'actionneur mécanique qui étire ou comprime la poutre 74 peut être réalisé différemment. Par exemple, il peut s'agir d'un actionneur thermique qui crée une différence de dilatation entre le substrat et la poutre. Il peut aussi s'agir d'un actionneur électrostatique.

**Revendications**

1. Capteur de champ magnétique comportant au moins un barreau magnétorésistif (20-23) comprenant un empilement (28 ; 72) d'au moins :

   - une première couche magnétique (30), dite « couche de référence » dont la direction d'aimantation est fixe et perpendiculaire à la direction longitudinale du barreau magnétorésistif à plus ou moins 10° près,
   - une seconde couche magnétique (34), dite « couche libre », dont l'axe de plus facile aimantation est parallèle à la direction longitudinale et dont l'aimantation peut tourner lorsqu'elle est soumise au champ magnétique à mesurer, et
   - une couche non magnétique (32), dite « espaceur », interposée entre les deux couches précédentes pour former une jonction tunnel ou une vanne de spin,

   la longueur du barreau dans sa direction longitudinale étant au moins vingt fois supérieure à sa plus grande largeur dans une direction transversale perpendiculaire à la direction longitudinale et parallèle aux couches de l'empilement,
   **caractérisé en ce que** :

   - la couche libre (34) est réalisée dans un matériau magnétostrictif qui présente un coefficient $\lambda_s$ de magnétostriction dont la valeur absolue est supérieure à 20 ppm à 25°C, et
   - le barreau magnétorésistif comporte une couche (44; 78) génératrice de contrainte apte à exercer une contrainte mécanique uniaxiale $\sigma$, parallèle à la direction longitudinale à plus ou moins 10° près, telle que le produit $\lambda_s\sigma$ soit positif et supérieur à 500 ppm.MPa à 25°C.

2. Capteur selon la revendication 1, dans lequel le capteur comporte un pont de Wheatstone comprenant une première et une seconde branches raccordées en parallèle entre un premier potentiel et un second potentiel,

   - la première branche comportant successivement, en allant du premier potentiel vers le second potentiel, un premier et un deuxième exemplaires (20, 21) du barreau magnétique raccordés en série par l'intermédiaire d'un premier point milieu (A),
   - la seconde branche comportant successivement, en allant du premier potentiel vers le second potentiel, un troisième et un quatrième exemplaires (22, 23) du barreau magnétique raccordés en série par l'intermédiaire d'un second point milieu (B).

3. Capteur selon la revendication 2, dans lequel les résistances des deuxième et troisième exemplaires (21, 22) du barreau magnétique varient dans le même sens lorsqu'ils sont soumis à une même variation du champ magnétique extérieur.

4. Capteur selon la revendication 3, dans lequel les résistances des premier, deuxième, troisième et quatrième exemplaires (20, 21, 22, 23) du barreau magnétique varient dans le même sens lorsqu'ils sont soumis à une même variation du champ magnétique extérieur.

5. Capteur de courant comportant :

   - un conducteur électrique (4) s'étendant le long d'une direction X, et
   - un capteur (16) de champ magnétique fixé sans aucun degré de liberté à ce conducteur électrique,

   **caractérisé en ce que** :

   - le capteur (16) de champ magnétique est conforme à l'une quelconque des revendications précédentes, et
   - le capteur de champ magnétique est fixé au conducteur électrique de manière à ce que la direction d'aimantation de la couche de référence du barreau magnétorésistif (20-23) soit perpendiculaire à la direction X à plus ou moins 10° près.

6. Capteur selon la revendication 5, dans lequel :

   - le conducteur électrique comporte un premier et un second brins (6,7) parallèles à la direction X, ces brins étant électriquement raccordés l'un à l'autre de manière à ce que le courant à mesurer circule dans un sens dans le premier brin et dans le sens opposé dans le second brin,
   - le capteur de champ magnétique est conforme à l'une quelconque des revendications 2 à 4, et
   - le deuxième exemplaire (21) du barreau magnétique s'étend le long du premier brin (6) et le troisième exemplaire (22) du barreau magnétique s'étend le long du second brin (7) de sorte que le deuxième exemplaire du barreau magnétique soit plus proche du premier brin que du deuxième brin et le troisième exemplaire du barreau magnétique soit plus proche du second brin que du premier brin.

7. Capteur selon la revendication 6, dans lequel le premier exemplaire (20) du barreau magnétique s'étend le long du premier brin (6) et le quatrième exemplaire (23) du barreau magnétique s'étend le long du second brin (7) de sorte que le premier exemplaire du barreau magnétique soit plus proche du premier brin que du deuxième brin et le quatrième exemplaire du barreau magnétique soit plus proche du second brin que du premier brin.

8. Barreau magnétorésistif pour un capteur de champ magnétique ou de courant conforme à l'une quelconque des revendications précédentes, ce barreau comportant un empilement (28 ; 72) d'au moins :

    - une première couche magnétique (30), dite « couche de référence » dont la direction d'aimantation est fixe et perpendiculaire à la direction longitudinale du barreau magnétorésistif à plus ou moins 10° près,
    - une seconde couche magnétique (34), dite « couche libre », dont l'axe de plus facile aimantation est parallèle à la direction longitudinale et dont l'aimantation peut tourner lorsqu'elle est soumise au champ magnétique à mesurer, et
    - une couche non magnétique (32), dite « espaceur », interposée entre les deux couches précédentes pour former une jonction tunnel ou une vanne de spin,

la longueur du barreau dans sa direction longitudinale étant au moins vingt fois supérieure à sa plus grande largeur dans une direction transversale perpendiculaire à la direction longitudinale et parallèle aux couches de l'empilement, **caractérisé en ce que** :

    - la couche libre (34) est réalisée dans un matériau magnétostrictif qui présente un coefficient $\lambda_s$ de magnétostriction dont la valeur absolue est supérieure à 20 ppm à 25°C, et
    - le barreau magnétorésistif comporte une couche (44 ; 78) génératrice de contrainte apte à exercer une contrainte mécanique uniaxiale $\sigma$ en tension, parallèle à la direction longitudinale à plus ou moins 10° près, telle que le produit $\lambda_s\sigma$ soit positif et supérieur à 500 ppm.MPa à 25°C.

9. Barreau selon la revendication 8, dans lequel la couche génératrice (44) est une couche précontrainte, différente des couches libres (34), de référence (30) et de l'espaceur (32), d'épaisseur supérieure à l'épaisseur de la couche libre, cette couche précontrainte exerçant en permanence la contrainte $\sigma$ sur la couche libre.

10. Barreau selon la revendication 9, dans lequel l'empilement des couches libres, de référence et de l'espaceur est sensiblement parallélépipédique et la couche précontrainte (44) recouvre au moins une partie d'une face dans la grande longueur du parallélépipède.

11. Barreau selon la revendication 8, dans lequel le barreau comporte :

    - un substrat rigide (78),
    - la couche génératrice (74) est une poutre d'épaisseur $\underline{e}$ dont les extrémités sont fixées sans aucun degré de liberté au substrat, cette poutre comportant une branche centrale qui s'étend entre les deux extrémités, cette branche centrale étant suspendue au-dessus du substrat,
    - un actionneur commandable apte à étirer ou à comprimer la branche centrale, et
    - l'empilement (72) est déposé sur une face de cette branche centrale de manière à ce que la contrainte uniaxiale appliquée par la branche centrale soit parallèle à la direction longitudinale à plus ou moins 10° près, l'épaisseur de l'empilement étant inférieure à l'épaisseur $\underline{e}$.

12. Barreau selon la revendication 11, dans lequel la couche libre est plus proche de la face de la branche centrale sur laquelle l'empilement est déposé que la couche de référence.

13. Barreau selon l'une quelconque des revendications 8 à 12, dans lequel la longueur du barreau est au moins quarante fois ou cent fois supérieure à sa largeur transversale.

**Patentansprüche**

1. Magnetfeldsensor, der wenigstens einen magnetoresistiven Stab (20-23) umfasst, der einen Stapel (28; 72) wenigstens aus Folgendem umfasst:

    - eine erste magnetische Schicht (30), die "Referenzschicht" genannt wird, deren Magnetisierungsrichtung fest und zu der Längsrichtung des magnetoresistiven Stabs bis auf plus oder minus 10° senkrecht ist,
    - eine zweite magnetische Schicht (34), die "freie Schicht" genannt wird, deren Achse mit schwächerer Magnetisierung zu der Längsrichtung parallel ist und deren Magnetisierung sich drehen kann, wenn sie dem zu messenden Magnetfeld unterworfen wird, und

- eine nicht magnetische Schicht (32), die "Abstandshalter" genannt wird, die zwischen die beiden obigen Schichten eingefügt ist, um einen Spin-Tunnel- oder Spin-Wannenübergang zu bilden,

wobei die Länge des Stabs in seiner Längsrichtung wenigstens zwanzigmal größer ist als seine größte Breite in einer Querrichtung senkrecht zu der Längsrichtung und parallel zu den Schichten des Stapels, **dadurch gekennzeichnet, dass**:

- die freie Schicht (34) aus einem magnetostriktiven Material verwirklicht ist, das einem Magnetostriktionskoeffizienten $\lambda_s$ aufweist, dessen Absolutwert bei 25 °C größer als 20 ppm ist, und
- der magnetoresistive Stab eine eine Beanspruchung erzeugende Schicht (44; 78) umfasst, die eine uniaxiale, zu der Längsrichtung bis auf plus oder minus 10° parallele Beanspruchung $\sigma$ ausüben kann, derart, dass das Produkt $\lambda_s\sigma$ bei 25 °C positiv und größer als 500 ppm NPa ist.

2. Sensor nach Anspruch 1, wobei der Sensor eine Wheatstone-Brücke umfasst, die einen ersten und einen zweiten Schenkel aufweist, die zwischen einem ersten Potential und einem zweiten Potential parallel geschaltet sind,

- wobei der erste Schenkel nacheinander von dem ersten Potential zu dem zweiten Potential ein erstes und ein zweites Exemplar (20, 21) des Magnetstabes, die über einen ersten Mittelpunkt (A) in Reihe geschaltet sind, umfasst,
- der zweite Schenkel nacheinander von dem ersten Potential zu dem zweiten Potential ein drittes und ein viertes Exemplar (22, 23) des Magnetstabs, die über einen zweiten Mittelpunkt (B) in Reihe geschaltet sind, umfasst.

3. Sensor nach Anspruch 2, wobei sich die Widerstände des zweiten und des dritten Exemplars (21, 22) des Magnetstabs im selben Richtungssinn ändern, wenn sie derselben Änderung des äußeren Magnetfeldes unterworfen werden.

4. Sensor nach Anspruch 3, wobei sich die Widerstände des ersten, des zweiten, des dritten und des vierten Exemplars (20, 21, 22, 23) des Magnetstabs im selben Richtungssinn ändern, wenn sie derselben Änderung des äußeren Magnetfeldes unterworfen werden.

5. Stromsensor, der Folgendes umfasst:

- einen elektrischen Leiter (4), der sich längs einer Richtung X erstreckt, und
- einen Magnetfeldsensor (16), der ohne Freiheitsgrad an diesem elektrischen Leiter befestigt ist,

**dadurch gekennzeichnet, dass**:

- der Magnetfeldsensor (16) wie in einem der vorhergehenden Ansprüche definiert beschaffen ist und
- der Magnetfeldsensor an dem elektrischen Leiter in der Weise befestigt ist, dass die Magnetisierungsrichtung der Referenzschicht des magnetoresistiven Stabs (20-23) zu der Richtung X bis auf plus oder minus 10° senkrecht ist.

6. Sensor nach Anspruch 5, wobei:

- der elektrische Leiter einen ersten und einen zweiten Zweig (6, 7) umfasst, die zu der Richtung X parallel sind, wobei diese Zweige miteinander in der Weise elektrisch verbunden sind, dass der zu messende Strom in einem Richtungssinn in dem ersten Zweig und im entgegengesetzten Richtungssinn in dem zweiten Zweig fließt;
- der Magnetfeldsensor wie in einem einem der Ansprüche 2 bis 4 definiert beschaffen ist und
- das zweite Exemplar (21) des Magnetstabs sich längs des ersten Zweigs (6) erstreckt und das dritte Exemplar (22) des Magnetstabs sich längs des zweiten Zweigs (7) erstreckt, derart, dass das zweite Exemplar des Magnetstabs sich näher bei dem ersten Zweig als bei dem zweiten Zweig befindet und das dritte Exemplar des Magnetstabs sich näher bei dem zweiten Zweig als bei dem ersten Zweig befindet.

7. Sensor nach Anspruch 6, wobei das erste Exemplar (20) des Magnetstabs sich längs des ersten Zweigs (6) erstreckt und das vierte Exemplar (23) des Magnetstabs sich längs des zweiten Zweigs (7) erstreckt, derart, dass sich das erste Exemplar des Magnetstabs näher bei dem ersten Zweig als bei dem zweiten Zweig befindet und dass sich das vierte Exemplar des Magnetstabs näher bei dem zweiten Zweig als bei dem ersten Zweig befindet.

8. Magnetoresistiver Stab für einen Magnetfeld- oder Stromsensor nach einem der vorhergehenden Ansprüche, wobei dieser Stab einen Stapel (28; 72) wenigstens aus dem Folgenden umfasst:

- eine erste magnetische Schicht (30), die "Referenzschicht" genannt wird, deren Magnetisierungsrichtung fest ist und zu der Längsrichtung des magnetoresistiven Stabs bis auf plus oder minus 10° senkrecht ist,

- eine zweite magnetische Schicht (34), die "freie Schicht" genannt wird, deren Achse mit geringerer Magnetisierung zu der Längsrichtung parallel ist und deren Magnetisierung sich drehen kann, wenn sie einem zu messenden Magnetfeld unterworfen wird, und

- eine nicht magnetische Schicht (32), die "Abstandshalter" genannt wird und die zwischen die zwei obigen Schichten eingefügt ist, um einen Spin-Tunnel- oder Spin-Wannenübergang zu bilden,

wobei die Länge des Stabs in seiner Längsrichtung wenigstens zwanzigmal größer ist als seine größte Breite in einer Querrichtung senkrecht zu der Längsrichtung und parallel zu den Schichten des Stapels, **dadurch gekennzeichnet, dass**:

- die freie Schicht (34) aus einem magnetostriktiven Material verwirklicht ist, das einen Magnetostriktionskoeffizienten $\lambda_s$ aufweist, dessen Absolutwert bei 25 °C größer als 20 ppm ist, und
- der magnetoresistive Stab eine eine Beanspruchung erzeugende Schicht (44; 78) umfasst, die eine uniaxiale mechanische Spannungsbeanspruchung $\sigma$ ausüben kann, die zu der Längsrichtung bis auf plus oder minus 10° parallel ist, derart, dass das Produkt $\lambda_s\sigma$ bei 25 °C positiv und größer als 500 ppm NPa ist.

**9.** Stab nach Anspruch 8, wobei die Erzeugungsschicht (44) eine Vorbeanspruchungsschicht ist, die von der freien Schicht (34), der Referenzschicht (30) und dem Abstandshalter (32) verschieden ist, deren Dicke größer als die Dicke der freien Schicht ist, wobei diese Vorbeanspruchungsschicht ständig die Beanspruchung $\sigma$ auf die freie Schicht ausübt.

**10.** Stab nach Anspruch 9, wobei der Stapel aus der freien Schicht, der Referenzschicht und dem Abstandshalter im Wesentlichen spatförmig ist und die Vorbeanspruchungsschicht (44) wenigstens einen Teil einer Fläche auf der großen Länge des Spats abdeckt.

**11.** Stab nach Anspruch 8, wobei der Stab Folgendes umfasst:

- ein starres Substrat (78),
- eine Erzeugungsschicht (74), die ein Träger mit Dicke $e$ ist, dessen Enden ohne Freiheitsgrad an dem Substrat befestigt sind, wobei dieser Träger einen mittleren Schenkel aufweist, der sich zwischen den zwei Enden erstreckt, wobei dieser mittlere Schenkel über dem Substrat aufgehängt ist,
- einen steuerbaren Aktor, der den mittleren Schenkel dehnen oder stauchen kann, und

- den Stapel (72), der auf einer Fläche dieses mittleren Schenkels in der Weise abgelagert ist, dass die uniaxiale Beanspruchung, die von dem mittleren Schenkel ausgeübt wird, zu der Längsrichtung bis auf plus oder minus 10° parallel ist, wobei die Dicke des Stapels kleiner als die Dicke $e$ ist.

**12.** Stab nach Anspruch 11, wobei sich die freie Schicht näher an der Fläche des mittleren Schenkels, auf der der Stapel abgelagert ist, als bei der Referenzschicht befindet.

**13.** Stab nach einem der Ansprüche 8 bis 12, wobei die Länge des Stabs wenigstens vierzigmal oder hundertmal größer ist als seine transversale Breite.

**Claims**

**1.** Magnetic field sensor comprising at least one magnetoresistive bar (20-23) comprising a stack (28; 72) of at least:

- a first magnetic layer (30), called the "reference layer", the magnetisation direction of which is fixed and perpendicular to the longitudinal direction of the magnetoresistive bar to within plus or minus 10°;
- a second magnetic layer (34), called the "free layer", the axis of easiest magnetisation of which is parallel to the longitudinal direction and the magnetisation of which may turn when it is subjected to the magnetic field to be measured; and
- a non-magnetic layer (32), called the "spacer", interposed between the two preceding layers in order to form a tunnel junction or a spin valve, the length of the bar in its longitudinal direction being at least twenty times larger than its largest width in a transverse direction perpendicular to the longitudinal direction and parallel to the layers of the stack,
**characterised in that**:
- the free layer (34) is made of a magnetostrictive material that has a magnetostriction coefficient $\lambda_s$ the absolute value of which is higher than 20 ppm at 25°C, and
- the magnetoresistive bar comprises a stress generating layer (44; 78) able to exert a uniaxial mechanical stress $\sigma$ parallel to the longitudinal direction to within plus or minus 10°, such that the product $\lambda_s\sigma$ is positive and higher than 500 ppm.MPa at 25°C.

**2.** Sensor according to Claim 1, in which the sensor comprises a Wheatstone bridge comprising first and second branches connected in parallel between a first potential and a second potential,

- the first branch comprising in succession, from the first potential to the second potential, first and second examples (20, 21) of the magnetic bar connected in series by way of a first midpoint (A),
- the second branch comprising in succession, from the first potential to the second potential, third and fourth examples (22, 23) of the magnetic bar connected in series by way of a second midpoint (B).

3. Sensor according to Claim 2, in which the resistances of the second and third examples (21, 22) of the magnetic bar vary in the same direction when they are subjected to a given variation in the external magnetic field.

4. Sensor according to Claim 3, in which the resistances of the first, second, third and fourth examples (20, 21, 22, 23) of the magnetic bar vary in the same direction when they are subjected to a given variation in the external magnetic field.

5. Current sensor comprising:

- an electrical conductor (4) extending along a direction X; and
- a magnetic field sensor (16) fixed with no degree of freedom to this electrical conductor,

**characterised in that**:

- the magnetic field sensor (16) is according to any one of the preceding claims, and
- the magnetic field sensor is fixed to the electrical conductor so that the magnetisation direction of the reference layer of the magnetoresistive bar (20-23) lies perpendicular to the direction X to within plus or minus 10°.

6. Sensor according to Claim 5, in which:

- the electrical conductor comprises first and second strands (6, 7) parallel to the direction X, these strands being electrically connected to each other so that the current to be measured flows in one direction in the first strand and in the opposite direction in the second strand;
- the magnetic field sensor is according to any one of Claims 2 to 4; and
- the second example (21) of the magnetic bar extends along the first strand (6) and the third example (22) of the magnetic bar extends along the second strand (7) so that the second example of the magnetic bar is closer to the first strand than the second strand and the third example of the magnetic bar is closer to the second strand than the first strand.

7. Sensor according to Claim 6, in which the first example (20) of the magnetic bar extends along the first strand (6) and the fourth example (23) of the magnetic bar extends along the second strand (7) so that the first example of the magnetic bar is closer to the first strand than the second strand and the fourth example of the magnetic bar is closer to the second strand than the first strand.

8. Magnetoresistive bar for a magnetic field or current sensor according to any one of the preceding claims, this bar comprising a stack (28; 72) of at least:

- a first magnetic layer (30), called the "reference layer", the magnetisation direction of which is fixed and perpendicular to the longitudinal direction of the magnetoresistive bar to within plus or minus 10°;
- a second magnetic layer (34), called the "free layer", the axis of easiest magnetisation of which is parallel to the longitudinal direction and the magnetisation of which may turn when it is subjected to the magnetic field to be measured; and
- a non-magnetic layer (32), called the "spacer", interposed between the two preceding layers in order to form a tunnel junction or a spin valve,

the length of the bar in its longitudinal direction being at least twenty times larger than its largest width in a transverse direction perpendicular to the longitudinal direction and parallel to the layers of the stack, **characterised in that**:

- the free layer (34) is made of a magnetostrictive material that has a magnetostriction coefficient $\lambda_s$ the absolute value of which is higher than 20 ppm at 25°C, and
- the magnetoresistive bar comprises a stress generating layer (44; 78) able to exert a tensile uniaxial mechanical stress $\sigma$ parallel to the longitudinal direction to within plus or minus 10°, such that the product $\lambda_s\sigma$ is positive and higher than 500 ppm.MPa at 25°C.

9. Bar according to Claim 8, in which the generating layer (44) is a prestressed layer different from the free layer (34), the reference layer (30) and the spacer (32), of thickness larger than the thickness of the free layer, this prestressed layer permanently exerting the stress $\sigma$ on the free layer.

10. Bar according to Claim 9, in which the stack of the free and reference layers and of the spacer is substantially parallelepipedal and the prestressed layer (44) covers at least some of one face along the large length of the parallelepiped.

11. Bar according to Claim 8, in which the bar comprises:

- a rigid substrate (78);
- the generating layer (74) is a beam of thickness $\underline{e}$ the ends of which are fixed with no degree of freedom to the substrate, this beam comprising a central leg that extends between the two ends, this central leg being suspended above the substrate;
- a controllable actuator able to stress or compress the central leg; and
- the stack (72) is deposited on one face of this central leg so that the uniaxial stress applied by the central leg is parallel to the longitudinal direction to within plus or minus 10°, the thickness of the stack being smaller than the thickness $\underline{e}$.

12. Bar according to Claim 11, in which the free layer is closer to the face of the central leg on which the stack is deposited than to the reference layer.

13. Bar according to any one of Claims 8 to 12, in which the length of the bar is at least forty times or one hundred times larger than its transverse width.

Fig. 1

Fig. 2

Fig. 3

Fig. 4

Fig. 9

Fig. 5

Fig. 6

Fig. 7

Fig. 8

## RÉFÉRENCES CITÉES DANS LA DESCRIPTION

**Documents brevets cités dans la description**

- US 20040137275 A
- US 6117569 A
- US 2008272771 A1
- DE 10054016 A1
- WO 2011001293 A
- FR 2905793

**Littérature non-brevet citée dans la description**

- **BILL DRAFTS.** Magnetoresistive Current Sensor Improves Motor Drive Perfomance. *Pacific Scientific - OECO, 4607 SE International Way*